Europäisches Patentamt

European Patent Office

Office européen des brevets

(19)

(11) Publication number : **0 476 898 B1**

(12) **EUROPEAN PATENT SPECIFICATION**

(45) Date of publication of patent specification :
20.12.95 Bulletin 95/51

(51) Int. Cl.⁶ : **H05K 1/00,** H05K 1/05,
H05K 3/00, H05K 3/44,
H05K 3/42, H05K 3/28

(21) Application number : 91308201.2

(22) Date of filing : 09.09.91

(54) **Circuit board and process for producing the same**

(30) Priority : 18.09.90 JP 246121/90
30.07.91 JP 190094/91

(43) Date of publication of application :
25.03.92 Bulletin 92/13

(45) Publication of the grant of the patent :
20.12.95 Bulletin 95/51

(84) Designated Contracting States :
DE FR GB

(56) References cited :
EP-A- 0 239 839
EP-A- 0 244 699
EP-A- 0 247 575
DE-A- 2 234 408
DE-B- 2 741 417
US-A- 4 609 586

(72) Inventor : Horikoshi, Eiji
1-3-6, Hachimandai
Isehara-shi, Kanagawa 259-11 (JP)
Inventor : Tani, Motoaki
Berumezon 512,
1-16-20, Sakae-cho
Atsugi-shi, Kanagawa 243 (JP)
Inventor : Watanabe, Isao
7-34-6, Sagamidai
Sagamihara-shi, Kanagawa 228 (JP)
Inventor : Natori, Katsuhide
3016-1, Nagatsuta-cho,
Midori-ku
Yokohama-shi, Kanagawa 227 (JP)
Inventor : Sato, Takehiro, Gurinhiru
Kamoshidanishi 23-101
569-1, Kamoshida-cho
Midori-ku, Yokohama-shi, Kanagawa 227 (JP)

(73) Proprietor : FUJITSU LIMITED
1015, Kamikodanaka,
Nakahara-ku
Kawasaki-shi, Kanagawa 211 (JP)

(74) Representative : Opperman, Stuart Richard et al
Haseltine Lake & Co.
Hazlitt House
28 Southampton Buildings
Chancery Lane
London WC2A 1AT (GB)

## Description

The present invention relates to a circuit board, having an electric circuit pattern formed on a surface thereof.

Various metals, resin-composites, and ceramics, have been proposed as materials for the supporting substrate or core of a printed circuit board.

US-A-4609586 describes a printed circuit board laminate including a support member, made of a metal such as aluminium, magnesium or copper, the metal being reinforced by graphite fibre incorporated in the support member. A printed wiring board, fabricated from dielectric fibre reinforced resin, is secured to the support member by means of a non-conducting adhesive such as an epoxy or polyimide resin. The inner bounding surface of a viahole drilled through the support member is plated with metal to form a conductor for use in connecting a circuit element on one side of the support member with one on the other side of that member, this conductor being insulated from the metal support member itself.

EP-A-0239839 describes a printed circuit board comprising an aluminium-based alloy substrate with viaholes formed therethrough to accommodate electrical conductors. The alloy consists, by weight, of 4.4% copper, 0.6% manganese, 1.5% magnesium, and 93.5% aluminium and normal impurities. The substrate, including particularly the interior bounding surfaces of the viaholes, is coated electrophoretically with electrically insulating acrylic or epoxy resin containing a thixotropic agent which is subsequently exposed by an etching process to facilitate adhesion of a metal layer to be deposited on the insulating coating. The metal layer is later etched to form a desired circuit pattern.

It is desirable to provide a reasonably simple method of producing a circuit board that will facilitate further miniaturization and weight reduction in portable electronic equipment.

According to one aspect of the present invention there is provided a method of producing a circuit board, comprising the steps of: (1) employing an electro-deposition-painting or anodic oxidation process to form, on a core consisting of magnesium and/or a magnesium-based alloy and/or a magnesium-based composite material, a first coating of an electrically insulating anti-moisture material; (2) forming a second coating, on the said first coating, which second coating is made of a heat-resisting and electrically insulating resin and has a viahole extending therethrough to the underlying first coating; (3) removing, by etching, a part of the first coating that is exposed at the bottom of the said viahole, whilst other parts of the first coating are masked by the second coating, so as to extend the viahole to the said core; (4) forming a metal film on a free surface region of the said second coating and on the inner bounding surface of the extended viahole; and (5) etching the metal film, using a photo-resist mask, to form therefrom a conductor layer having a predetermined circuit pattern.

According to a second aspect of the present invention there is provided a circuit board comprising: a core consisting of magnesium and/or a magnesium-based alloy and/or a magnesium-based composite material; a first coating of a heat-resisting and electrically insulating anti-moisture material provided on the core by electrodeposition-painting or anodic oxidation; a second coating, of a heat resisting and electrically insulating resin, formed on the first coating and having a viahole extending therethrough to the said first coating, which viahole is extended through the first coating to the said core; and a metal film formed on the said second coating, so as to extend through the said viahole to the said core, and etched to provide a circuit pattern thereon.

According to a third aspect of the present invention there is provided an electronic device as defined in claim 10.

Reference will now be made, by way of example, to the accompanying drawings, in which:

Figures 1(a) and 1(b) show perspective and side sectional views respectively of an electronic pocket notebook incorporating a circuit board made in accordance with an embodiment of the present invention;

Figures 2(a) and 2(b) show perspective and side sectional views respectively of a portable telephone incorporating a circuit board made in accordance with an embodiment of the present invention;

Figures 3(a) and 3(b) show respective sectional views of circuit boards, made in accordance with embodiments of the present invention, produced by (a) printing and (b) a thin film circuit process;

Figures 4(a) and 4(b) show partial sectional views of respective circuit boards made in accordance with embodiments of the present invention, treated for corrosion protection;

Figures 5(a) and 5(b) show respective sectional views of composite materials used as the core materials of circuit boards made in accordance with embodiments of the present invention;

Figures 6(a) to 6(g) show respective sectional views illustrating successive steps in the production of a circuit board according to an embodiment of the present invention; and

Figures 7(a) to 7(d) show respective sectional views illustrating successive steps, following the step of Figure 6(g), in the production of a multilayered circuit board according to an embodiment of the present invention.

Magnesium is one of the lightest weight metals for practical applications and has a high specific strength (strength with respect to unit volume). Magnesium, as it is a metallic material, has significantly higher thermal conductivity and a significantly lower electrical resistivity than nonmetallic materials such as a glass-epoxy composite, alumina ceramics, etc., sometimes used conventionally as core materials for printed circuit boards, as shown in Table 1. A high thermal conductivity can enable heat generated in electronic devices to be efficiently released therefrom, and a low electrical resistivity can facilitate the provision of good electromagnetic shielding.

## Table 1
## Properties of Core Materials for Circuit Boards

| Material | Copper | Iron | Aluminum | Magnesium | Glass–Epoxy | Alumina ceramics |
|---|---|---|---|---|---|---|
| Density ($g/cm^3$) | 8.9 | 7.8 | 2.7 | 1.7 | 1.6 | 3.7 |
| Thermal conductivity (W/m–K) | 394 | 73.3 | 238 | 167 | 0.3 | 28.1 |
| Thermal expansion coefficient ($x \ 10^{-6}/K$) | 17.1 | 12.2 | 23.9 | 26.1 | 110 | 6 |
| Electrical resistivity ($\mu\Omega$–cm) | 1.7 | 10.1 | 2.7 | 4.2 | ⊾ $10^{18}$ | ⊾ $10^{20}$ |
| Bending strength ($kg/mm^2$) | 35 | 55 | 30 | 20 | 40 | 35 |

An embodiment of the invention can provide a high performance circuit board, which is lighter in weight than conventional circuit boards, due to the use of a core material comprising magnesium, and which is extremely lightweight and provides good strength, heat release, and electromagnetic shielding.

A magnesium alloy can provide a core with a higher strength than a pure magnesium core, while retaining the inherent light weight of magnesium, and a magnesium-based composite can provide an even higher strength.

The core material advantageously consists of a magnesium-based alloy containing one or more alloying elements selected from the group consisting of aluminium, zinc, zirconium, and lithium, particularly from the viewpoint of strength. An addition of these elements can make the core strength from 1.2 to 3 times greater than that of a pure magnesium core.

To further increase the core strength, the core material may consist of a magnesium-based composite material which comprises: a matrix phase consisting of magnesium or a magnesium alloy containing one or more alloying elements selected from the group consisting of aluminium, zinc, zirconium, and lithium; and a reinforcement phase in the form of particles, whiskers, or fibers, dispersed in the matrix phase and consisting of one or more elements or compounds selected from the group consisting of boron, carbon, boron carbide, silicon carbide, and alumina. Such a composite material can provide a core strength of up to 1.5 to 2 times higher than that of the matrix phase.

A higher core strength (specified strength) assists in providing a further miniaturized and lighter weight circuit board.

Preferably the core is used to form at least part of the body of an electronic device or a casing accommodating an electronic device.

As magnesium is chemically active, the core is provided with a coating of anti-moisture material to provide corrosion protection. This material is also electrically insulating.

Such corrosion protection of a magnesium-based structural material can commercially be provided in the form of an anodic oxidized coating or an electrodeposition-painted coating. Electrodeposition painting is preferred for forming a dense electrically insulating coating on the core surface.

Polyimide materials, in which minute viaholes can readily be formed, are known for use as insulating films in thin film circuit devices, but it is practically impossible to form an insulating polyimide coating directly on a magnesium-based core, because an imidization during the curing of the liquid resin at about 300°C, for example, generates a water phase which reacts with the magnesium-based core and exfoliates the polyimide coating from the core.

In the production of a circuit board according to one embodiment of this invention a dense antimoisture electrodeposition-painted coating is first formed on a magnesium-based core, and a polyimide insulating coating is then formed thereon. A viahole is formed in the polyimide insulating coating, and this is followed by an etching of the electrodeposition-painted coating, using the polyimide coating as a mask, to extend the viahole to the magnesium-based core.

Polyimide resins are electrically insulating and have a high heat resistance, such that no deterioration thereof occurs at an elevated temperature encountered in a later soldering step, and therefore need not be removed, after being used as a mask for the etching, but can be retained as an insulating film in a finally completed circuit board. Polyimide is easily applied on a core by spin coating or dip coating, for example.

Fluororesins, epoxy resins, and acrylic resins, for example, may be used as alternatives to polyimide resins, although they have disadvantages in that fluororesins are difficult to apply and epoxy and acrylic resins have relatively poor heat resistance.

Polyimide has a drawback in that it is relatively expensive. Japanese Patent Application No. 2-279088 discloses a blended resin composed of polyimide and acrylic monomer, which can reduce the material cost while ensuring the necessary properties such as the heat resistance.

Preferred embodiments of the present invention are illustrated in more detail by way of the following examples.

Example 1

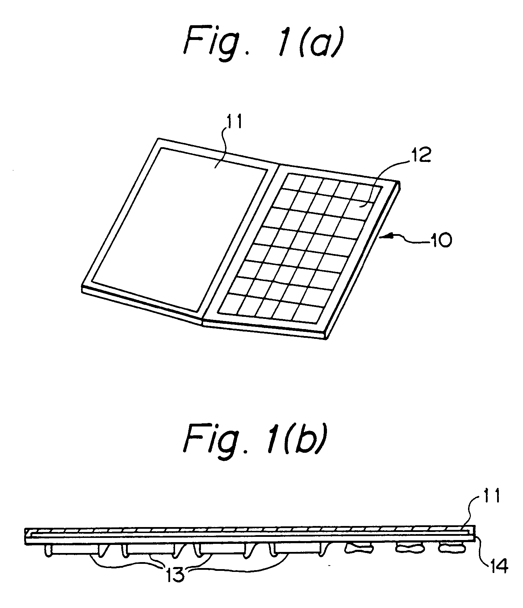

Figure 1 shows an electronic pocket notebook 10 in which a circuit board made in accordance with an embodiment of the present invention is used as a structural member: Fig. 1(a) being a perspective view showing the electronic pocket notebook 10 opened to expose one side provided with a film liquid crystal 11 and the opposite side provided with a keyboard 12: and Fig. 1(b) being a side sectional view of the display unit incorporated in the notebook 10, including the film liquid crystal 11.

The film liquid crystal 11 is so flexible that it cannot support itself and is stuck on and held by a circuit board 14. Electric elements 13 are arranged on one side of the circuit board 14 to form an electric circuit and the film liquid crystal 11 is stuck on the other side. The circuit board 14 serves as a structural support for the film liquid crystal 11, and incorporates the driver of a display circuit and the circuit portion of the electronic pocket notebook 10.

The electronic pocket notebook 10 of Fig. 1 has a size corresponding to the "A5" paper size (ISO or JIS) when opened, a thickness of about 5 mm, and a weight of 120 g, which is thinner by 2mm and lighter by 40 g than a conventional electronic pocket notebook of the same "A5" size, in which a liquid crystal is held on a glass plate and a glass-epoxy composite circuit board is used.

Example 2

In a conventional portable telephone, an electromagnetic shield plate of copper or aluminium, on which no circuit parts are mounted, is provided separately from a printed circuit board made of glass-epoxy composite for mounting parts.

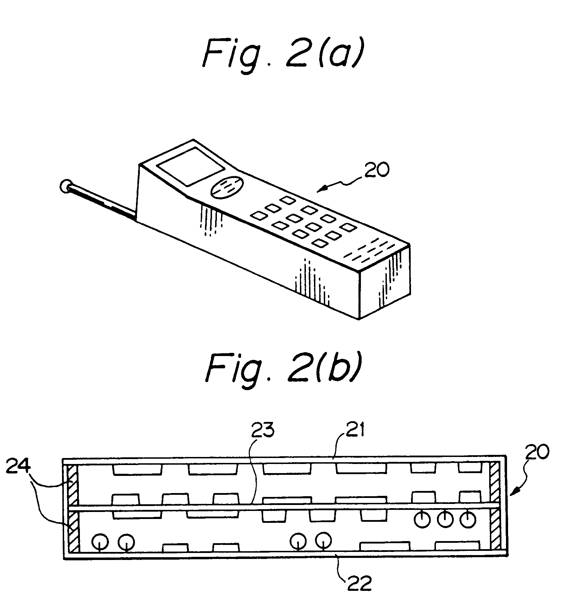

Figure 2 shows a portable telephone 20 in which a circuit board made in accordance with an embodiment of the present invention is used as an electromagnetic shield plate as well as part of the structure of the telephone 20, Fig. 2(a) being a perspective view of the telephone 20 and Fig. 2(b) being a sectional view at the half width region of the telephone 20.

Electric circuits are formed on one side of each of two circuit boards 21 and 22 having an "L"-shaped section and assembled in a manner such that the sides of the circuit boards 21 and 22 are facing each other to form a casing of the telephone 20. Another circuit board 23, on both sides of which electric circuits are formed, is arranged at the midthickness of the casing, and a connector 24 connects these circuits boards 21, 22 and 23. The circuit boards 21 and 22 composing the casing also function as an electromagnetic shield plate, and thereby the packaging density, or miniaturization, can be made greater in comparison with the conventional portable telephone. Moreover, a reduced weight of the circuit board directly leads to a lightened weight of the telephone as a whole.

A surprising miniaturization and weight reduction can thus be achieved, the volume of a telephone being reduced from 450 cc to 120 cc and the weight being reduced from 750 g to 230 g.

Moreover, because magnesium has a superior thermal conductivity, there is no need for special additional means to distribute heat radiation from the semiconductor devices used in the electrical circuitry, which also facilitates miniaturization and weight reduction.

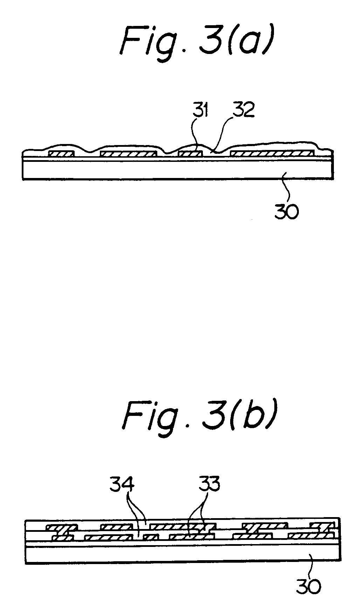

An electrical circuit board can be made, in accordance with an embodiment of the present invention, by printing a conductive paste 31 and an insulating resin 32 on a coated core material 30 as shown in Fig. 3(a) or by a thin film circuit process in which a conductor film 33 is formed by vapor deposition or sputtering and an insulating film 34 is then formed by spin coating as shown in Fig. 3(b). The printing method is cheap but has a limited refinement, whereas the thin film circuit technique can provide a refinement as fine as several $\mu$m, so the latter is preferred for high density packaging.

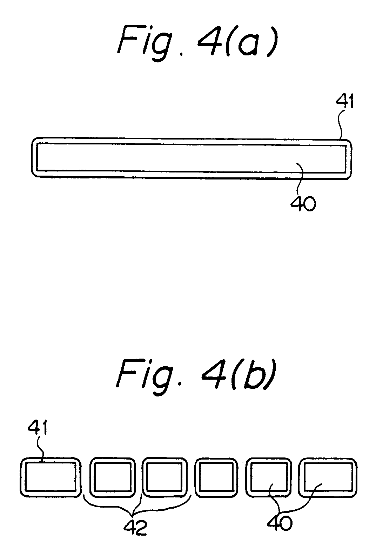

Because magnesium is chemically active and has a poor corrosion resistance, it is necessary, as shown in Fig. 4(a), to coat the core material 40 with a corrosion protective and electrically insulating coating 41, by an electrically insulating treatment such as electrodeposition painting or anodic oxidation. Because of the good workability of magnesium, a throughhole can be easily formed by machining, if required. An insulated and corrosion protected throughhole may be formed by machining a throughhole 42 and then forming the above-mentioned coating 41 as shown in Fig. 4(b).

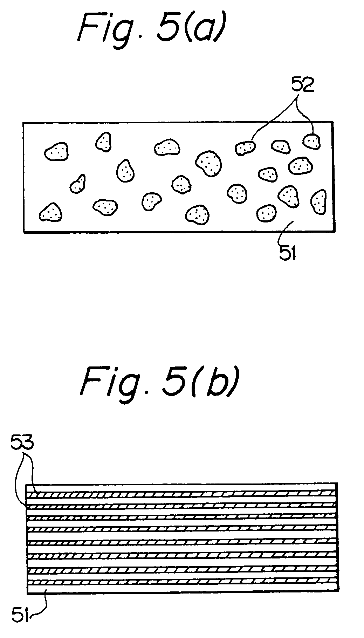

The magnesium-based composite materials that may be used as core materials in embodiments of the present invention include a composite material such as is shown in Fig. 5, made of a magnesium-based matrix 51 with reinforcing particles 52 (Fig. 5(a)), whiskers or fibers 53 (Fig. 5(b)), made of boron, carbon, boron carbide, silicon carbide, or alumina (Fig. 5(a)).

Example 3

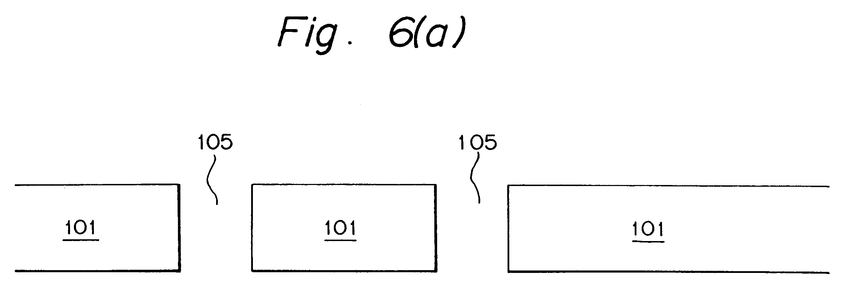

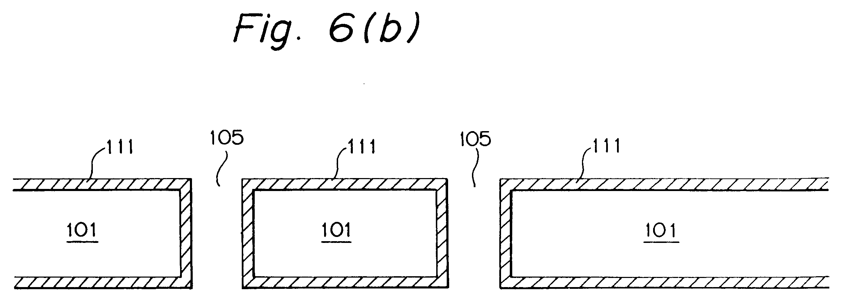

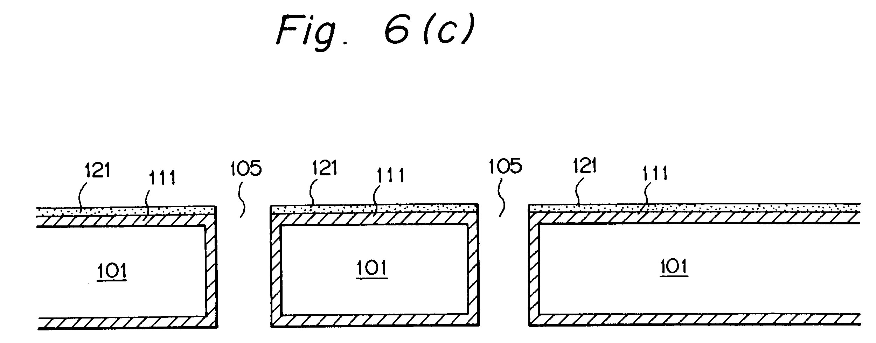

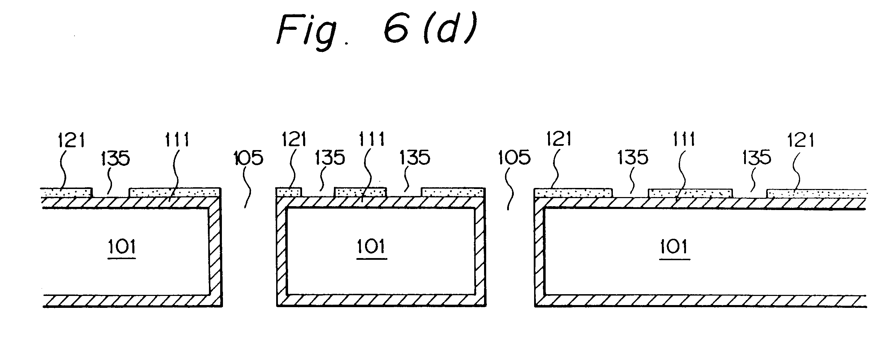

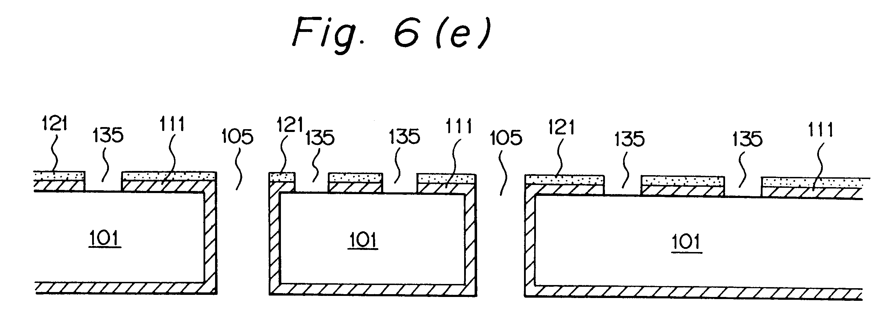

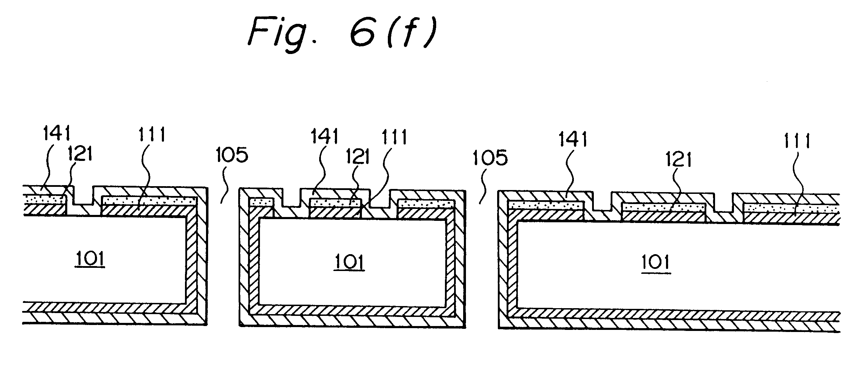

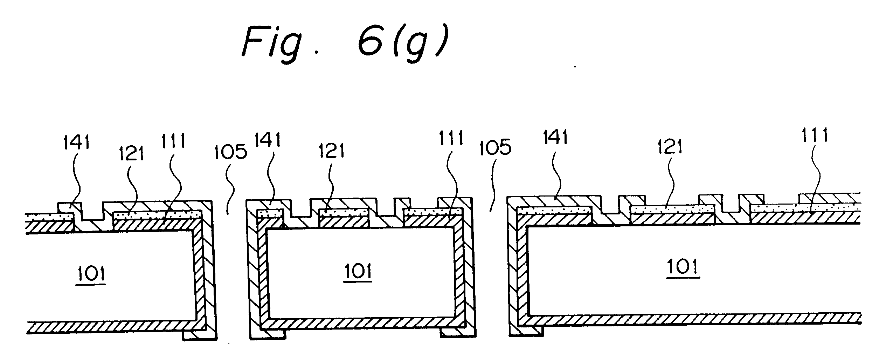

Referring to Figs. 6(a) to 6(g), a process for producing a circuit board in accordance with an embodiment of the present invention will be described below.

Step 0

As shown in Fig. 6(a), 0.2 to 2 mm diameter throughholes 105 were formed (two of which are shown in the Figure) by drilling a 76 x 76 mm square, 0.5 mm thick core 101 of a magnesium-based alloy (ASTM AZ31).

Step 1

As shown in Fig. 6(b), a 20 $\mu$m thick electrodeposition-painted coating 111 was formed on the entire surface of the core 101 by cation deposition of a primarily epoxy resin in which an amino group had been introduced, under a current density of from 1 to 10 A/dm$^2$.

Step 2

A photosensitive polyimide was spin-coated, at a rotation speed of from 500 to 6000 rpm, on the electrodeposition-painted coating 111 on the upper surface of the core 101, to form a 10 $\mu$m thick polyimide coating 121, as shown in Fig. 6(c). The polyimide coating was then prebaked at a temperature of from 80 to 120°C for 1 hour.

Step 3

As shown in Fig. 6(d), 10 to 100 $\mu$m diameter viaholes 135 were formed in the polyimide coating 121 by exposing the polyimide coating 121, using a glass mask, to an ultraviolet light having a wavelength of 365 nm at an energy of 300 mJ, and then carrying out a wet type development in which a developer of N-methyl-2-pyrolidone (NMP) and a rinse of ethyl alcohol were used.

Step 4

The electrodeposition-painted coating 111 exposed through the viaholes 135 was dry-etched with CF$_4$ gas, using the polyimide coating 121 as a resist mask, so that the viaholes 135 were extended through the electrodeposition-painted coating 111 and reached the core material 101, as shown in Fig. 6(e).

Usually, resist mask material must be removed after an etching process, but a polyimide coating can endure a high temperature processing such as soldering and need not be removed. It can therefore be retained and used as an insulating layer of the final electrical circuit board, to provide the board with improved heat resistance.

## Step 5

As shown in Fig. 6(f), a metal film of copper 141 was formed on the polyimide coating 121, the electrodeposition-painted coating 111, the inner bounding surfaces of the viaholes 135, and the core material 101 exposed in the viaholes 135, by a chemical plating or electroplating process.

## Step 6

A resist layer (not shown) having a reversed pattern of a predetermined circuit pattern was formed on the metal film 141, which was then etched with an etchant solution composed mainly of ferric chloride, using the resist layer as a mask, to form a conductor layer of the metal film 141 having the predetermined circuit pattern, as shown in Fig. 6(g).

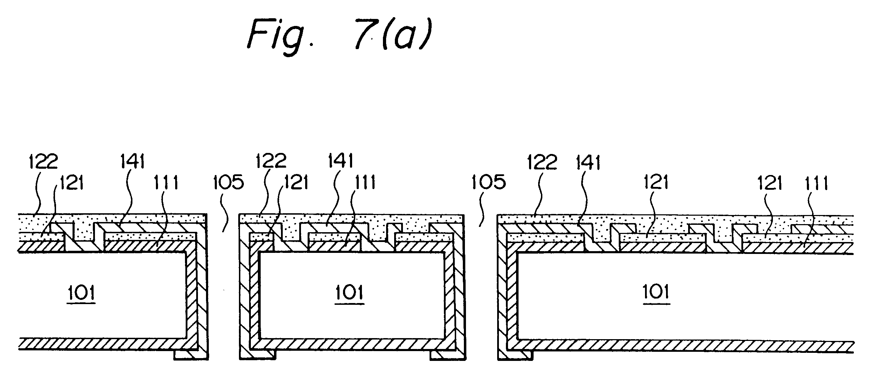

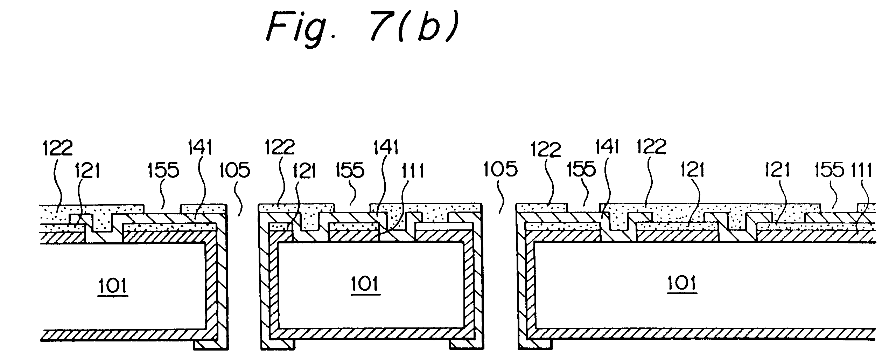

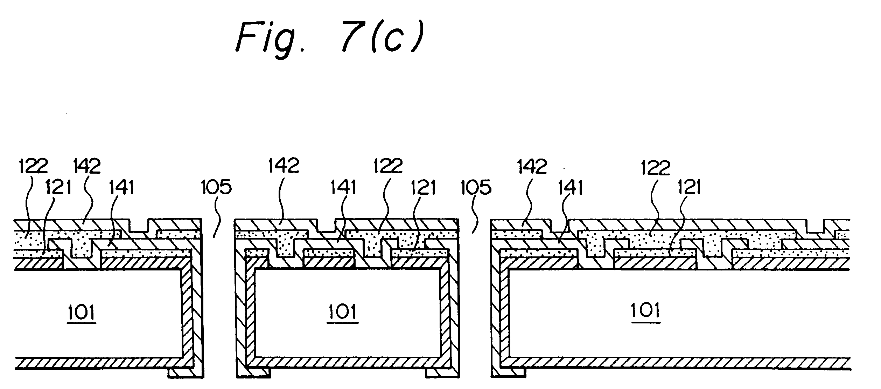

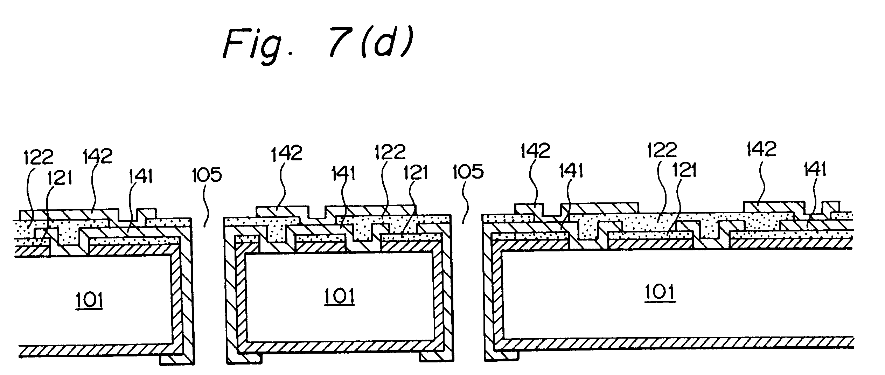

A multilayered circuit board can be produced by forming other conductor layers on the above-prepared circuit board in a manner as shown in Figs. 7(a) to 7(d), for example, in the following sequence.

## Additional Step 7

As shown in Fig. 7(a), a polyimide coating 122 is formed on the entire upper surface of the structure resulting from step 6 above, in a manner similar to the previous step 2.

## Additional Step 8

As shown in Fig. 7(b), viaholes 155 are formed in the polyimide coating 122 to expose the metal film 141 therebelow, in a manner similar to the previous step 3.

## Additional Step 9

As shown in Fig. 7(c), a metal film 142 is formed in a manner similar to the previous step 5.

## Additional Step 10

As shown in Fig. 7(d), the metal film 142 is etched to form a predetermined circuit pattern of conductor material, in a manner similar to the previous step 6.

The previous steps 0 to 6 and the additional steps 7 to 10 provide a multilayered circuit board having two conductor layers 141 and 142.

A further multiplication of conductor layers can be obtained by repeating the additional steps 7 to 10 the required number of times.

## Claims

1. A method of producing a circuit board, comprising the steps of:-

(1) employing an electro-deposition-painting or anodic oxidation process to form, on a core (101) consisting of magnesium and/or a magnesium-based alloy and/or a magnesium-based composite material, a first coating (111) of an electrically insulating anti-moisture material;

(2) forming a second coating (121), on the said first coating, which second coating is made of a heat-resisting and electrically insulating resin and has a viahole (135) extending therethrough to the underlying first coating;

(3) removing, by etching, a part of the first coating (111) that is exposed at the bottom of the said viahole (135), whilst other parts of the first coating (111) are masked by the second coating (121), so as to extend the viahole (135) to the said core (101);

(4) forming a metal film (141) on a free surface region of the said second coating (121) and on the inner bounding surface of the extended viahole (135); and

(5) etching the metal film (141), using a photo-resist mask, to form therefrom a conductor layer having a predetermined circuit pattern.

**2.** A method as claimed in claim 1, wherein step (5) is followed by the steps of:-
(A) forming a further coating (122) of an electrically insulating resin so as to cover the said conductor layer (141) and the underlying second coating (121), which further coating (122) has a viahole (155) extending therethrough to an upper surface region of the underlying conductor layer (141);
(B) forming a second metal film (142), on a free surface region of the said further coating (122) and on the inner bounding surface of the viahole (155) extending through that coating; and
(C) etching the second metal film (142), using a photo-resist mask, to form therefrom a second conductor layer having a predetermined pattern.

**3.** A method as claimed in claim 1 or 2, wherein the said second coating (121) is made from a polyimide resin.

**4.** A method as claimed in claim 1 or 2, wherein the said second coating (121) is made from a blended resin consisting of a polyimide and an acrylic monomer.

**5.** A method as claimed in any preceding claim, wherein the said second coating (121) is made from photosensitive material and the viahole therethrough is formed by exposing and developing that material.

**6.** A circuit board comprising:
a core (101) consisting of magnesium and/or a magnesium-based alloy and/or a magnesium-based composite material;
a first coating (111) of an electrically insulating anti-moisture material provided on the core (101) by electrodeposition-painting or anodic oxidation;
a second coating (121), of a heat-resisting and electrically insulating resin, formed on the first coating and having a viahole (135) extending therethrough to the said first coating (111), which viahole is extended through the first coating (111) to the said core (101); and
a metal film (141) formed on the said second coating (121), so as to extend through the said viahole (135) to the said core (101), and etched to provide a circuit pattern thereon.

**7.** A circuit board as claimed in claim 6, wherein the said second coating (121) is made from a polyimide resin.

**8.** A circuit board as claimed in claim 6, wherein the second coating (121) is made from a blended resin consisting of a polyimide and an acrylic monomer.

**9.** A circuit board as claimed in claim 6, 7 or 8, wherein the core material comprises:
a matrix phase (51) consisting of a magnesium-based alloy containing one or more alloying elements selected from the group consisting of aluminium, zinc, zirconium and lithium; and
a reinforcement phase (52,53), in the form of particles, whiskers or fibres, dispersed in the matrix phase and consisting of one or more elements or compounds selected from the group consisting of boron, carbon, boron carbide, silicon carbide and alumina.

**10.** An electronic device (20) incorporating a circuit board as claimed in any one of claims 6 to 9, so as to form at least part of a casing (21,22) of that device.

**Patentansprüche**

**1.** Ein Verfahren zum Herstellen einer Schaltungsplatte mit den Schritten:-
(1) Anwenden eines Elektroabscheidungsfarbauftrags- oder anodischen Oxydationsprozesses, um auf einem Kern (101), der aus Magnesium und/oder einer Legierung auf Magnesiumbasis und/oder einem Verbundmaterial auf Magnesiumbasis besteht, einen ersten Überzug (111) aus einem elektrisch isolierenden Feuchtigkeitsschutzmaterial zu bilden;
(2) Bilden eines zweiten Überzugs (121) auf dem genannten ersten Überzug, welcher zweite Überzug aus einem wärmebeständigen und elektrisch isolierenden Harz hergestellt ist und ein Durchgangsloch (135) hat, das sich durch diesen hindurch bis zu dem darunterliegenden ersten Überzug erstreckt;
(3) Entfernen, durch Ätzen, eines Teils des ersten Überzugs (111), der auf dem Boden des genannten Durchgangslochs (135) exponiert ist, während andere Teile des ersten Überzugs (111) durch den zweiten Überzug (121) maskiert sind, um das Durchgangsloch bis zu dem genannten Kern (101) zu verlängern;

(4) Bilden eines Metallfilms (141) auf einer freien Oberflächenzone des genannten zweiten Überzugs (121) und auf der inneren Grenzfläche des verlängerten Durchgangslochs (135); und

(5) Ätzen des Metallfilms (141) unter Verwendung einer Fotoresistmaske, um aus ihm eine Leiterschicht zu bilden, die ein vorbestimmtes Schaltungsmuster hat.

2. Ein Verfahren nach Anspruch 1, bei dem Schritt (5) die Schritte folgen:-

(A) Bilden eines weiteren Überzugs (122) aus einem elektrisch isolierenden Harz, um die genannte Leiterschicht (141) und den darunterliegenden zweiten Überzug (121) zu bedecken, welcher weitere Überzug (122) ein Durchgangsloch (155) hat, das sich durch ihn hindurch bis zu einer oberen Oberflächenzone der darunterliegenden Leiterschicht (141) erstreckt;

(B) Bilden eines zweiten Metallfilms (142) auf einer freien Oberflächenzone des genannten weiteren Überzugs (122) und auf der inneren Grenzfläche des Durchgangslochs (155), das sich durch jenen Überzug erstreckt; und

(C) Ätzen des zweiten Metallfilms (142) unter Verwendung einer Fotoresistmaske, um aus ihm eine zweite Leiterschicht zu bilden, die ein vorbestimmtes Muster hat.

3. Ein Verfahren nach Anspruch 1 oder 2, bei dem der genannte zweite Überzug (121) aus einem Polyimidharz hergestellt wird.

4. Ein Verfahren nach Anspruch 1 oder 2, bei dem der genannte zweite Überzug (121) aus einem Mischharz aus einem Polyimid und einem Akrylmonomer hergestellt wird.

5. Ein Verfahren nach irgendeinem vorgehenden Anspruch, bei dem der genannte zweite Überzug (121) aus fotoempfindlichem Material hergestellt wird und das Durchgangsloch durch diesen hindurch durch Belichten und Entwikkeln von jenem Material gebildet wird.

6. Eine Schaltungsplatte mit:

einem Kern (101), der aus Magnesium und/oder einer Legierung auf Magnesiumbasis und/oder einem Verbundmaterial auf Magnesiumbasis besteht;

einem ersten Überzug (111) aus einem elektrisch isolierenden Feuchtigkeitsschutzmaterial, der auf dem Kern (101) durch Elektroabscheidungsanstrich oder anodische Oxydation vorgesehen ist;

einem zweiten Überzug (121) aus einem wärmebeständigen und elektrisch isolierenden Harz, der auf dem ersten Überzug gebildet ist und ein Durchgangsloch (135) hat, das sich durch ihn hindurch bis zu dem genannten ersten Überzug (111) erstreckt, welches Durchgangsloch durch den ersten Überzug (111) hindurch bis zu dem genannten Kern (101) verlängert ist; und

einem Metallfilm (141), der auf dem genannten zweiten Überzug (121) gebildet ist, um sich durch das genannte Durchgangsloch (135) bis zu dem genannten Kern (101) zu erstrecken, und geätzt ist, um ein Schaltungsmuster auf ihm vorzusehen.

7. Eine Schaltungsplatte nach Anspruch 6, bei der der genannte zweite Überzug (121) aus einem Polyimidharz hergestellt ist.

8. Eine Schaltungsplatte nach Anspruch 6, bei der der genannte zweite Überzug (121) aus einem Mischharz aus einem Polyimid und einem Akrylmonomer hergestellt ist.

9. Eine Schaltungsplatte nach Anspruch 6, 7 oder 8, bei der das Kernmaterial umfaßt:

eine Matrixphase (51) aus einer Legierung auf Magnesiumbasis, die eines oder mehrere Legierungselemente enthält, die ausgewählt sind aus der Gruppe bestehend aus Aluminium, Zink, Zirconium und Lithium; und

eine Verstärkungsphase (52, 53) in Form von Partikeln, Whiskers oder Fasern, die in der Matrixphase dispergiert sind und aus einem oder mehreren Elementen oder Verbindungen bestehen, die ausgewählt sind aus der Gruppe bestehend aus Bor, Kohlenstoff, Borcarbid, Siliziumcarbid und Aluminiumoxid.

10. Eine elektronische Vorrichtung (20), die eine Schaltungsplatte nach irgendeinem der Ansprüche 6 bis 9 enthält, um wenigstens einen Teil eines Gehäuses (21, 22) von jener Vorrichtung zu bilden.

**Revendications**

1. Procédé de fabrication d'une carte de circuit, comprenant les étapes de :

   (1) utilisation d'un processus d'application de peinture par électrodépôt ou d'oxydation anodique pour former, sur un support de base (101) constitué par du magnésium et/ou par un alliage à base de magnésium et/ou par un matériau composite à base de magnésium, un premier revêtement (111) en un matériau anti-humidité électriquement isolant ;

   (2) formation d'un second revêtement (121) sur ledit premier revêtement, lequel second revêtement est réalisé en une résine résistant à la chaleur et électriquement isolante et comporte un trou de passage (135) le traversant qui arrive jusqu'au premier revêtement sous-jacent ;

   (3) enlèvement par gravure d'une partie du premier revêtement (111) qui est mise à nu au niveau du fond dudit trou de passage (135) tandis que d'autres parties du premier revêtement (111) sont masquées par le second revêtement (121) de manière à étendre le trou de passage (135) jusqu'audit support de base (101) ;

   (4) formation d'un film métallique (141) sur une région de surface libre dudit second revêtement (121) et sur la surface de frontière interne du trou de passage étendu (135) ; et

   (5) gravure du film métallique (141) en utilisant un masque de photoréserve pour former à partir de celui-ci une couche conductrice présentant un motif de circuit prédéterminé.

2. Procédé selon la revendication 1, dans lequel l'étape (5) est suivie par les étapes de :

   (A) formation d'un revêtement supplémentaire (122) en une résine électriquement isolante de manière à recouvrir ladite couche conductrice (141) et le second revêtement sous-jacent (121), lequel revêtement supplémentaire (122) comporte un trou de passage (155) le traversant de manière à arriver jusqu'à une région de surface supérieure de la couche conductrice sous-jacente (141) ;

   (B) formation d'un second film métallique (142) sur une région de surface libre dudit revêtement supplémentaire (122) et sur la surface de frontière interne du trou de passage (155) s'étendant au travers de ce revêtement ; et

   (C) gravure du second film métallique (142) en utilisant un masque de photoréserve pour former à partir de celui-ci une seconde couche conductrice présentant un motif prédéterminé.

3. Procédé selon la revendication 1 ou 2, dans lequel ledit second revêtement (121) est réalisé à partir d'une résine polyimide.

4. Procédé selon la revendication 1 ou 2, dans lequel ledit second revêtement (121) est réalisé à partir d'une résine mixte comprenant un polyimide et un monomère acrylique.

5. Procédé selon l'une quelconque des revendications précédentes, dans lequel ledit second revêtement (121) est réalisé à partir d'un matériau photosensible et le trou de passage le traversant est formé en exposant et en développant ce matériau.

6. Carte de circuit comprenant :

   un support de base (101) constitué par du magnésium et/ou un alliage à base de magnésium et/ou un matériau composite à base de magnésium ;

   un premier revêtement (111) en un matériau anti-humidité électriquement isolant appliqué sur le support de base (101) au moyen d'une application de peinture par électrodépôt ou d'une oxydation anodique ;

   un second revêtement (121) constitué par une résine résistant à la chaleur et électriquement isolante, formé sur le premier revêtement et comportant un trou de passage (135) s'étendant au travers jusqu'audit premier revêtement (111), lequel trou de passage est étendu au travers du premier revêtement (111) jusqu'audit support de base (101) ; et

   un film métallique (141) formé sur ledit second revêtement (121), de manière à s'étendre au travers dudit trou de passage (135) jusqu'audit support de base (101), et gravé pour constituer un motif de circuit dessus.

7. Carte de circuit selon la revendication 6, dans laquelle ledit second revêtement (121) est réalisé à partir d'une résine polyimide.

8. Carte de circuit selon la revendication 6, dans laquelle le second revêtement (121) est réalisé à partir d'une résine mixte comprenant un polyimide et un monomère acrylique.

9. Carte de circuit selon la revendication 6, 7 ou 8, dans laquelle le matériau du support de base comprend :

une phase matricielle (51) constituée par un alliage à base de magnésium contenant un ou plusieurs éléments d'alliage choisis parmi le groupe comprenant l'aluminium, le zinc, le zirconium et le lithium ; et

une phase de renforcement (52, 53), sous la forme de particules, de filaments ou de fibres, dispersée dans la phase matricielle, et constituée par un ou plusieurs éléments ou composés sélectionnés parmi le groupe comprenant du bore, du carbone, du carbure de bore, du carbure de silicium et de l'alumine.

10. Dispositif électronique (20) incorporant une carte de circuit selon l'une quelconque des revendications 6 à 9, de manière à former au moins une partie d'un boîtier (21,22) de ce dispositif.

# Fig. 1(a)

# Fig. 1(b)

# Fig. 2(a)

# Fig. 2(b)

# Fig. 3(a)

# Fig. 3(b)

# Fig. 4(a)

# Fig. 4(b)

## Fig. 5(a)

## Fig. 5(b)

EP 0 476 898 B1

# Fig. 6(a)

105

105

101

101

101

Fig. 6(b)

EP 0 476 898 B1

# Fig. 6 (c)

EP 0 476 898 B1

# Fig. 6 (d)

# Fig. 6 (e)

EP 0 476 898 B1

EP 0 476 898 B1

# Fig. 6 (f)

# Fig. 6(g)

EP 0 476 898 B1

EP 0 476 898 B1

# Fig. 7(a)

Fig. 7(b)

# Fig. 7(c)

Fig. 7(d)